# DEMANDE DE BREVET EUROPEEN

(11) **EP 1 049 169 A1**
(43) Date de publication de la demande: **02.11.2000**
(21) Numéro de dépôt: 00401139.1
(22) Date de dépôt: 25.04.2000
(51) Int. Cl.: H01L 27/144, H01L 31/12

(54) **Dispositif émetteur récepteur optronique a diaphotie reduite**

(30) Priorité: 28.04.1999 FR 9905363
(71) Demandeur: ALCATEL, 75008 Paris (FR)
(72) Inventeur: Nakajima, Hisao, 92220 Bagneux (FR)
(74) Mandataire: Brykman, Georges

(57) **Abrégé**

Dans un dispositif semi-conducteur (1) d'émission réception de signaux optiques modulés ayant un substrat semi-conducteur sur lequel sont intégrés de façon monolithique un émetteur (4) apte à émettre un signal formé par une lumière modulée porté par une première longueur d'onde, un récepteur (6) apte à détecter un signal de réception formé par une lumière modulée porté par une seconde longueur d'onde, on prévoit en outre un capteur (10) d'un signal représentatif de bruits parasites et des moyens de soustraction (11,13,15) pour soustraire du signal de réception, un signal de compensation formé à partir du signal représentatif de bruits parasites capté par le capteur (10) du signal représentatif de bruits parasites. L'invention est également relative à un procédé dans lequel on capte le bruit parasite à proximité du récepteur, et on soustrait du signal reçu par le récepteur un signal formé à partir du signal de bruit parasite capté.

## Description

### Domaine technique

La présente invention est relative à un dispositif semi-conducteur d'émission réception de signaux optiques modulés sur lequel sont intégrés de façon monolithique un émetteur et un récepteur optique ainsi que des moyens pour réduire la diaphotie entre l'émetteur et le récepteur.

### Arrière plan technologique.

Il est couramment admis que les communications bidirectionnelles seront assurées par des circuits optroniques intégrés comportant sur un même circuit un émetteur émettant par exemple sur une longueur d'onde de 1,3 µm et un récepteur recevant sur une longueur d'onde de 1,55 µm ou inversement émettant sur une longueur d'onde de 1,55 µm et recevant sur une longueur d'onde de 1,3 µm. Un point relatif aux espoirs et difficultés de réalisation de tels circuits, fait l'objet d'un article dans le "Journal of Quantum Electronics", selon la référence [1], dans la liste des références annexée à cette demande.

L'une des difficultés est due aux problèmes de diaphoties entre l'émetteur et le récepteur du circuit intégré.

Bien que le laser d'émission opère à une longueur d'onde, par exemple, de 1,3 µm et que la photodiode de réception soit optimisée pour avoir une sensibilité maximum à une longueur d'onde de 1,55 µm, la photodiode est également sensible à la longueur d'onde de 1,3 µm, émise à proximité par le laser avec une puissance qui peut atteindre plusieurs centaines de fois le niveau de saturation de la photodiode.

Il en résulte un problème bien connu de diaphotie.

Ainsi, la demande de brevet européen n° EP 732 782 [2] décrit-elle un circuit optronique intégré en ligne dans lequel un absorbant de la longueur d'onde émise par le laser est placé entre l'émetteur et la photodiode de réception. On obtient ainsi un récepteur avec un rapport signal/bruit amélioré.

Des améliorations à ce mode de réduction de la diaphotie sont décrites dans la demande de brevet EP n°0 755 082, [3].

Plusieurs sections absorbantes sont disposées entre l'émetteur et le récepteur. La multiplication des sections absorbantes permet d'obtenir une diaphotie acceptable, de l'ordre de - 40 dB sans augmentation excessive de la longueur du dispositif. Cette solution est plus efficace que celle qui consisterait à augmenter la longueur d'une section unique.

La demande de brevet EP 0 795 910 [4] décrit également un circuit optronique intégré comportant des moyens pour réduire la diaphotie entre l'émetteur et le récepteur dans lequel les moyens pour réduire la diaphotie comportent un électro-absorbant placé entre l'émetteur et le récepteur. L'électro-absorbant a une largeur de bande interdite comprise entre la largeur de bande interdite d'un matériau laser constituant une couche active de l'émetteur et la largeur de bande interdite d'un matériau laser constituant une couche active du récepteur. Ces moyens absorbants peuvent être complétés par une couche électro-absorbante supplémentaire apte à absorber la lumière de l'émetteur.

Les moyens décrits jusqu'à présent sont des moyens passifs avec lesquels on vise à diminuer le bruit produit dans la photodiode de réception, par l'émetteur laser placé à proximité.

On a aussi cherché à réduire le bruit provoqué par l'émetteur dans le récepteur, de façon active. Ainsi, dans un article [5] intitulé "Full Duplex Performance Assessment of In line Transceivers Emitting at 1,3 µm and receiving at 1,55 µm/s", les auteurs expliquent comment ils ont réduit la diaphotie de façon active.

Ils ont utilisé une structure à trois sections comprenant un laser d'émission DFB à réflecteur distribué à 1,3 µm, un laser à cavité de Fabry Perot tenant lieu de photodiode de réception à 1,55 µm et une section d'absorption à 1,3 µm placée entre les deux sections laser.

Les expériences faites visaient à évaluer la capacité d'amélioration que l'on peut obtenir en réduisant le coefficient de modulation m' représentant la modulation du signal émis à 1,3 µm tel que reçu au niveau du récepteur à 1,55 µm.

Deux méthodes ont été utilisées.

Selon une première méthode, on module simultanément le signal émis par un signal de données et la section d'absorption par un signal complémentaire du signal de données obtenu par un déphasage à 180° du signal de données.

Selon la seconde méthode, le signal de données est envoyé après réglage d'atténuation et de phase vers une entrée d'un amplificateur différentiel recevant sur une seconde entrée le signal détecté par la photodiode de réception à 1,55 µm. De la sorte, le signal résultant en sortie de l'amplificateur différentiel est un signal de différence entre le signal et le bruit reçu par la photodiode et le signal de modulation de données de l'émetteur à 1,3 µm.

Grâce à ces procédés, il a pu être obtenu une sensibilité de - 23,9 dBm et - 19,1 dBm pour des vitesses de transmission de 68 Mb/S et 196 Mb respectivement, en communication duplex complète.

Ces chiffres sont proches de ceux que l'on obtient lorsque le laser à 1,3 µm n'est pas modulé. A la connaissance de l'inventeur les meilleurs résultats obtenus à la date de publication du document [5] avec un circuit optronique intégré l'ont été avec un circuit émetteur récepteur en ligne, comportant une section intermédiaire d'absorption. Plus récemment avec une nouvelle structure permettant l'absorption de la lumière non guidée, pour une puissance optique modulée de deux mW crête à crête en émission, une sensibilité supérieure à - 31 dBm a été mesurée pour une communication duplex complète à 155 Mb. La pénalité due au duplex complet est évaluée à 1dB. Cependant, des fuites du laser d'émission sont toujours présentes et il n'a pas été possible d'obtenir une sensibilité similaire avec une plus forte modulation du laser. Actuellement, on ne voit pas comment éviter les fuites parasites vers la photodiode de réception en raison des limitations géométriques dues aux dimensions que l'on veut de plus en plus réduites du circuit optronique intégré de façon monolithique.

### Brève description de l'invention

L'idée à la base de l'invention est de réduire de façon active les bruits dus à la lumière parasite de l'émetteur en plaçant un capteur de lumière parasite au voisinage de la photodiode de détection. On soustrait ensuite, par exemple avec un amplificateur différentiel, le signal issu du capteur, du signal capté par la photodiode. En résumé l'invention est relative à un procédé d'amélioration de la sensibilité de détection d'un signal reçu par un récepteur d'un circuit optronique intégré caractérisé en ce que :
- on capte le bruit parasite à proximité du récepteur,
- on soustrait du signal reçu par le récepteur un signal de compensation formé à partir du signal de bruit parasite capté.

Ce procédé est réalisé par un dispositif semiconducteur d'émission réception de signaux optiques modulés réalisé sur un substrat semiconducteur sur lequel sont intégrés de façon monolithique un premier composant semiconducteur ayant une première couche active, ce premier composant étant un émetteur apte à émettre un signal émis formé par une lumière modulée porté par une première longueur d'onde, un second composant semiconducteur ayant une seconde couche active, ce second composant étant un récepteur apte à détecter un signal de réception formé par une lumière modulée porté par une seconde longueur d'onde, dispositif caractérisé en ce qu'il inclut en outre un capteur d'un signal représentatif d'un bruit parasite et des moyens de soustraction pour soustraire du signal de réception, un signal de compensation formé à partir du signal représentatif du bruit parasite capté par ledit capteur.

Ainsi, grâce à ce dispositif en ajustant la phase et l'amplitude du signal capté par le capteur du circuit monolithique réglé sur la longueur d'onde d'émission on compense les fuites du signal d'émission et on améliore sensiblement le rapport signal/bruit du récepteur.

Le dispositif monolithique peut être un dispositif en ligne, comme décrit par exemple dans la demande de brevet EP 0 755 082 A1, [3] ou un composant en surface comme décrit par exemple dans un article de METZGER et al. paru dans les actes du 20^{ème} colloque européen sur les communications optiques ECOC 94 tenu à FIRENZE, Italie pages 87-90 et intitulé "Photonic integrated transceiver for access network" [6].

De préférence, le capteur du signal parasite et le récepteur ont des structures semi-conductrices similaires de façon à avoir les mêmes fluctuations de longueur d'onde avec les variations de température.

### Brève description des dessins

L'invention sera maintenant mieux comprise et distinguée de l'art antérieur par la description qui va suivre d'exemples de réalisation de l'invention qui sera faite en référence aux dessins annexés dans lesquels :
- la figure 1 représente un schéma de principe d'un circuit optronique en ligne conforme à la présente invention ;
- la figure 2 représente un schéma de principe d'un circuit optronique en surface conforme à la présente invention ;
- la figure 3 représente deux courbes de valeur de diaphotie en fonction de la fréquence de modulation, l'une sans le capteur selon l'invention et l'autre avec ; et
- la figure 4 représente des courbes représentant le logarithme du taux d'erreur sur bit en fonction de la puissance moyenne reçue par le récepteur.

### Description de modes de réalisation

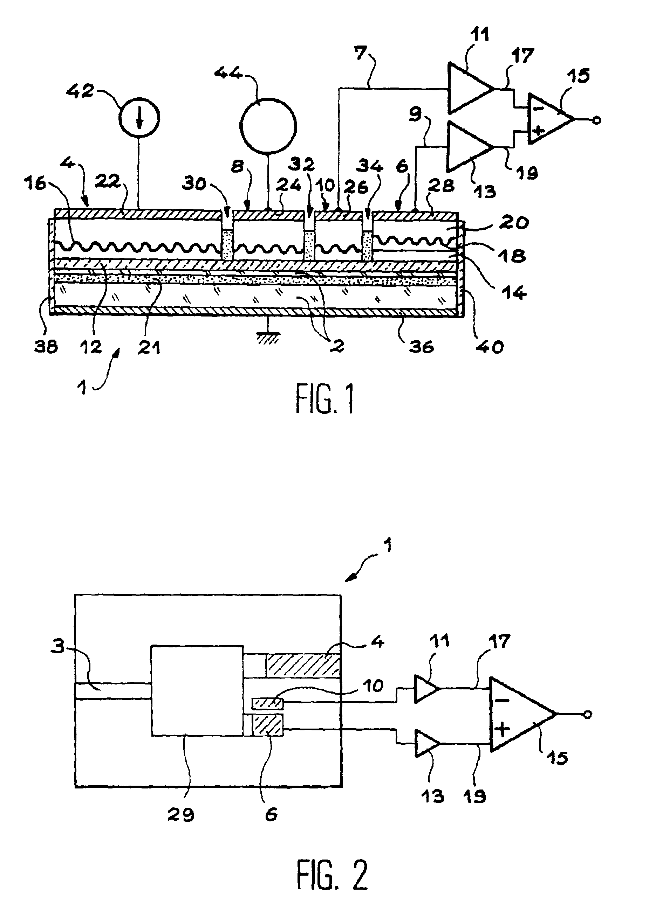

Le dispositif 1 conforme à l'invention qui est schématiquement représenté sur la figure 1, comprend en ligne sur un substrat semi-conducteur 2, une section d'émission laser 4, une section d'absorption 8, destinée à absorber la lumière émise vers l'arrière par la section d'émission laser 4, un capteur 10 destiné à capter la lumière parasite se trouvant à proximité d'une dernière section 6. Cette section 6 est une photodiode intégrée recevant de la lumière à la longueur d'onde de 1,55 µm modulée. Le signal délivré par le capteur 10 est dirigé vers une entrée 7 d'un amplificateur 11. La sortie 17 de cet amplificateur constitue une première entrée pour un amplificateur différentiel 15. Le signal capté par le récepteur 6 est envoyé vers une entrée 9 d'un amplificateur 13. La sortie 19 de cet amplificateur constitue une seconde entrée pour l'amplificateur différentiel 15.

Plus précisément le dispositif de la figure 1 comprend sur le substrat 2, par exemple InP dopé N, une première couche active 12 à la longueur d'onde de 1,3 µm qui est commune aux sections 4, 8, 10 et 6, et une seconde couche 14 active à la longueur d'onde de 1,55 µm, qui s'étend dans la section 6, par exemple au-dessus de la couche 12, comme on le voit sur la figure 1. Un réseau de Bragg 16 dont la longueur d'onde de Bragg vaut 1,3 µm s'étend au-dessus de la couche active 12. Ce réseau est également présent pour des raisons de simplification de construction au-dessus de la couche 12 des sections 8 et 10 et éventuellement au-dessus de la couche 14 de la section 6. Dans le cas où le composant 1 serait aussi utilisé en temps qu'émetteur à 1,55 µm on aura intérêt à prévoir un réseau de Bragg 18 à 1,55 µm au-dessus de la couche 14.

Ces réseaux 16 et éventuellement 18 sont recouverts par une couche de confinement 20 par exemple en InP dopé P. Cette couche de confinement 20 est recouverte par des couches conductrices 22, 24, 26, et 28 respectivement au niveau des sections 4, 8, 10, et 6. Une couche d'absorption 21 est insérée entre le guide d'onde formé par la couche active 12 et le substrat 2. Cette couche 21 est séparée de la couche 12 par une couche de séparation de même composition que la couche 2 et qui pour cette raison a été référencé 2 également. Des zones 30, 32, 34 sont gravées à partir de la face supérieure du dispositif à travers ces couches conductrices et jusque dans la couche 20 pour assurer l'isolation électrique des couches 22, 24, 26 et 28 les unes par rapport aux autres, comme on le voit sur la figure 1. La face inférieure du dispositif, c'est à dire la face inférieure du substrat 2 est recouverte d'une couche conductrice 36 pour mise à la masse. On constate ainsi que, dans cet exemple de réalisation, les structures semi-conductrices des sections 8 et 10 sont semblables. Il s'ensuit que ces sections auront un même comportement avec les changements de température. La face avant du dispositif, c'est à dire celle qui est située du côté de la section 4 est recouverte d'une couche antireflet 38. La face arrière du dispositif, c'est à dire celle qui est située du côté de la couche 14 est recouverte d'une couche de haute réflectivité 40. Il est précisé que les couches 38 et 40 ne sont pas obligatoires. Des moyens de polarisation 42, 44 sont prévus pour polariser les couches conductrices 22 et 28 respectivement.

Le fonctionnement est le suivant :

La section laser 4 est polarisée et modulée par un signal de données I_{b} appliqué aux moyens de polarisation 42. La section d'absorption 8 est polarisée de façon inverse de façon à obtenir une absorption maximum de la lumière provenant du laser à 1,3 µm et dirigée vers l'arrière. La lumière provenant du laser comprend la lumière guidée et non guidée et contient à la fois de la lumière stimulée et de la lumière résultant d'émission spontanée. On veut dire par-là que la lumière captée par la section d'absorption 8 arrive par la couche active 12 mais aussi d'ailleurs. Cette lumière ne contient pas seulement la lumière stimulée provenant directement de la couche 12, mais aussi des lumières parasites émises par la couche 12 à d'autres longueurs d'onde puisque l'émission spontanée a une bande spectrale large. Il s'ensuit que ces lumières ont des spectres optiques et des réponses de modulation différentes de ce qui va être filtré et émis. Il s'ensuit que la section d'absorption 8 va présenter une efficacité d'absorption inégale pour les différentes longueurs d'onde du spectre. L'efficacité d'absorption peut être réduite pour la lumière non guidée, spontanée et stimulée, et pour la lumière guidée spontanée. L'inefficacité de la section d'absorption pour la lumière non guidée est due au fait que la section d'absorption 8 n'est pas traversée par cette lumière non guidée et n'a en conséquence aucune action sur elle. L'inefficacité de la section d'absorption pour la lumière guidée spontanée est due au fait que l'absorbant ne peut être optimisé pour absorber le spectre entier de l'émission spontanée. Malgré l'efficacité démontrée de la couche d'absorption 21 pour empêcher la propagation de lumière non guidée allant vers et réfléchie par la couche substrat 2 cette technique ne peut empêcher la propagation latérale de la lumière. C'est pourquoi malgré la présence de ces éléments passifs destinés à prévenir la pollution du récepteur par l'émetteur, il subsiste une pollution résiduelle.

L'idée à la base de l'invention est de capter au voisinage de la section formant composant récepteur 6 un signal représentatif, dans la bande du récepteur, de la fuite de lumière due à la section formant composant émetteur 4. Ce rôle est dévolu au capteur 10 qui est destiné à capter l'intensité et la phase de la lumière de fuite. Ce signal représentatif de la lumière de fuite reçu par le récepteur 6, amplifié par l'amplificateur 11 est soustrait du signal de réception au moyen de l'amplificateur différentiel 15. Ainsi en réglant le niveau d'amplification de l'amplificateur 11 du signal de fuite on peut compenser l'influence de ce signal dans le signal de réception.

Il convient de noter que la structure du capteur 10 est, à l'exception de la couche additionnelle 14 de réception à 1,55 µm, la même que celle du récepteur 6. Le capteur 10 et le récepteur 6 sont aussi proche que possible l'un de l'autre, le capteur étant immédiatement adjacent au récepteur. En conséquence le signal parasite capté par la couche 12 de la section 10 est toujours proche de celui capté par la couche de réception 14 dans le récepteur 6.

Un autre exemple de réalisation dans lequel les différents composants du circuit optronique 1 sont réalisés en surface et non plus en ligne est représenté schématiquement figure 2. Sur cette figure les éléments ayant même fonction que ceux de la figure 1, portent le même numéro de référence. Les lumières des circuits d'émission et de réception sont séparées l'une de l'autre de façon connue en soi au moyen d'un filtre 29 de séparation de longueur d'onde (WDM). Les lumières sont reçue et émise par un guide d'onde 3. Il est important de noter que le capteur 10 est situé aussi proche que possible du récepteur 6, le capteur ayant un côté immédiatement adjacent à un côté du récepteur, de façon à recevoir un signal parasite qui soit aussi proche que possible du signal parasite effectivement reçu par le récepteur 6. Les circuits optroniques de surface sont en eux-mêmes connus. Pour plus de détails sur leur réalisation, on pourra se reporter par exemple à l'article déjà cité de Metzger et Al [6].

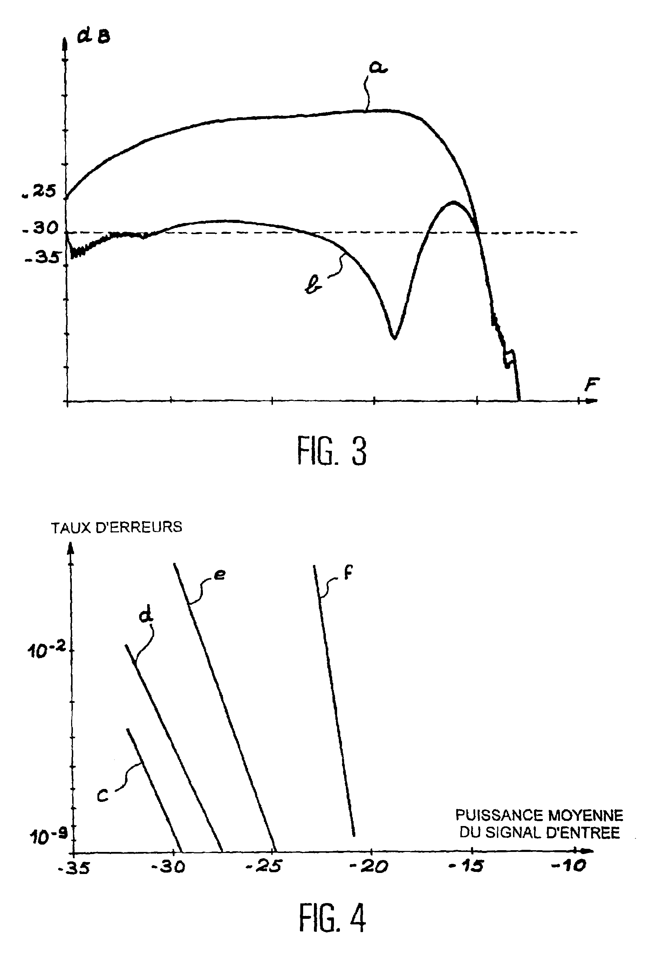

Des résultats obtenus avec un circuit tel que celui représenté figure 1, mais pour un composant émettant à 1,55 µm et recevant à 1,3 µm sont illustrés par les courbes représentées sur les figures 3 et 4. Sur la figure 3 les courbes a et b représentent sur la largeur de bande utile le niveau de diaphotie en fonction de la fréquence. La courbe a représente ce niveau de diaphotie sans la soustraction du signal parasite. La courbe b représente ce niveau de diaphotie avec soustraction du signal parasite au moyen du capteur 10 et de l'amplificateur différentiel 15 On voit que le niveau de diaphotie est amélioré en moyenne d'une quinzaine de décibels sur toute la bande.

La figure 4 représente les taux d'erreurs exprimés par le logarithme du rapport entre le nombre d'erreurs moyen et le nombre de bits transmis, en fonction de la puissance moyenne du signal reçu par le récepteur 6, exprimée en décibels. Les courbes c et d représentent ce taux d'erreur lorsque l'émetteur 4 n'est pas polarisé (courant de polarisation = 0 mA) et lorsque l'émetteur est polarisé par un courant de 40 mA respectivement. Les courbes e et f représentent ce même taux d'erreur lorsque la communication est une communication duplex totale se faisant avec un débit moyen de 68 mégabits par seconde dans les deux sens. La courbe e, avec soustraction du signal parasite capté par le capteur 10, et la courbe f, sans soustraction de ce même signal. Les courbes de la figure 4 montrent d'une part que la réception est effectivement perturbée par la mise en route de l'émetteur, malgré les précautions passives prises. Elles montrent d'autre part que la sensibilité de réception est sensiblement améliorée par la mise en oeuvre du dispositif selon l'invention.

### Annexe.

### Liste de références.

**[1]** T.L. Koch and U. Koren, « Semiconductor photonic integrated circuit », IEEE J. Quantum Electronic., QE 27, P.641-653, 1991.
**[2]** L. Goldstein, J.L. Gentner, F. Brillouet « Optical duplex device » Brevet FR 9503057, EP 732782.
**[3]** Demande de brevet EP n°0 755 082, H. Nakajima et J. Charil, "Dispositif semi-conducteur d'émission réception notamment à 1,3 µm et 1,55 µm, brevet n° FR 95 08611, déposé le 17 juillet 1995.
**[4]** Demande de brevet EP 0 795 910 H. Nakajima et J. Charil, "Dispositif semi-conducteur d'émission-réception à faible diaphotie", Brevet n° FR 96 03080, déposé le 12 mars 1996,
**[5]** H.Nakajima, A. Leroy, et J. Charil, « Full Duplex Performance Assessment of In line Transceivers Emitting at 1,3 µm and receiving at 1,55 µm/s » paru dans "IEEE photonics technology letters, vol 8, n° 11 novembre 1996, p.1561-1563.
**[6]** METZGER et al, actes du 20^{ème} colloque européen sur les communications optiques ECOC 94 tenu à FIRENZE, Italie pages 87-90 intitulé "Photonic integrated transceiver for the access network"

## Revendications

1. Dispositif (1) semiconducteur d'émission et de réception de signaux optiques modulés réalisé sur un substrat (2) semi-conducteur sur lequel sont intégrés de façon monolithique un premier composant (4) semi-conducteur ayant première une couche active (12), ce premier composant étant un émetteur (4) apte à émettre un signal émis formé par une lumière modulée porté par une première longueur d'onde, un second composant (6) semiconducteur ayant une seconde couche active (14), ce second composant (6) étant un récepteur (6) apte à détecter un signal de réception formé par une lumière modulée porté par une seconde longueur d'onde, dispositif caractérisé en ce qu'il inclut en outre un capteur (10) d'un signal représentatif d'un bruit parasite et des moyens de soustraction (11,13,15) pour soustraire du signal de réception, un signal de compensation formé à partir du signal représentatif du bruit parasite capté par ledit capteur (10).

2. Dispositif d'émission réception de signaux optiques selon la revendication 1 caractérisé en ce que le récepteur (6) et le capteur (10) sont disposés en ligne, le capteur (10) étant immédiatement adjacent au récepteur (6).

3. Dispositif d'émission réception de signaux optiques selon la revendication 2 caractérisé en ce que des moyens d'absorption (8) sont disposés entre l'émetteur (4) et le capteur (10).

4. Dispositif d'émission réception de signaux optiques selon la revendication 1 caractérisé en ce que le récepteur (6) et le capteur (10) sont disposés en surface, le capteur (10) ayant un côté immédiatement adjacent à un côté du récepteur (6).

5. Dispositif d'émission réception de signaux optiques selon l'une des revendications 1 à 4 caractérisé en ce que les structures semi-conductrices (36,2,21,12,20) du capteur (10) et du récepteur (6) sont semblables.

6. Procédé d'amélioration de la sensibilité de détection d'un signal reçu par un récepteur d'un circuit optronique intégré caractérisé en ce que :
- on capte le bruit parasite à proximité du récepteur,
- on soustrait du signal reçu par le récepteur un signal de compensation formé à partir du signal de bruit parasite capté.
